# EUROPÄISCHE PATENTANMELDUNG

(11) **EP 1 369 915 A2**
(43) Veröffentlichungstag der Anmeldung: **10.12.2003**
(21) Anmeldenummer: 03007717.6
(22) Anmeldetag: 04.04.2003
(51) Int. Cl.: H01L 23/34, G01K 7/18

(54) **Halbleiterbauelement mit integrierter Schaltung, Kühlkörper und Temperatursensor**

(30) Priorität: 07.06.2002 DE 10225602
(71) Anmelder: Heraeus Sensor-Nite GmbH, 63450 Hanau (DE)
(72) Erfinder: Wienand, Karlheinz, Dr., 63741 Aschaffenburg (DE); Ullrich, Karlheinz, Dr., 64823 Gross-Umstadt (DE)
(74) Vertreter: Kühn, Hans-Christian

(57) **Zusammenfassung**

Ein Halbleiterbauelement mit einer integrierten Schaltung (1) weist einen Kühlkörper (13) als Wärmesenke sowie einen damit thermisch verbundenen Temperatursensor (7) auf, dessen Widerstand von der Temperatur abhängig ist; der Temperatursensor (7) enthält einen Dünnfilm-Messwiderstand, der auf einer elektrisch isolierenden Oberfläche eines folienartigen Substrats aufgebraucht ist, wobei die gesamte Dicke des Temperatursensors im Bereich von 10 µm bis 100 µm liegt. Der Dünnfilm-Messwiderstand ist als ebenes Bauteil ausgebildet, wobei der Temperatursensor (7) zwischen der integrierten Schaltung (1) und dem Kühlkörper (13) angeordnet ist.

Der Dünnfilm-Messwiderstand ist auf einer Seite mit einer an den Kühlkörper angrenzenden thermischen Ankopplungsschicht (12) versehen, während er auf der anderen Seite mit seinem Substrat an einen Wärmeverteiler (4) grenzt, der wenigstens zum Teil die integrierte Schaltung (1) umgibt.

## Beschreibung

Die Erfindung betrifft ein Halbleiterbauelement mit einer integrierten Schaltung und einem damit thermisch verbundenen Temperatursensor, dessen Widerstand von der Temperatur abhängig ist, sowie mit einem Kühlkörper als Wärmesenke.

Der Begriff _{"}integrierte Schaltung" umfasst eine in einem Gehäuse eingekapselte integrierte elektronische Schaltung auf Halbleiterbasis (lC), während der eingangs genannte Begriff _{"}Halbleiterbauelement" auf ein komplettes Bauelement mit Kühlkörper gerichtet ist.

Aus der EP 0 350 015 B1 ist ein Halbleiterbauelement mit einem Gehäuse bekannt, das mindestens einen Leistungs-MOSFET und einen mit diesem thermisch verbundenen Sensor enthält, wobei der Sensor in Abhängigkeit von der Temperatur seinen Widerstand zwischen zwei seiner Anschlüsse ändert. Als Temperatursensor ist ein Thyristor vorgesehen, es kann jedoch auch ein Bipolar-Transistor eingesetzt werden. Auf diese Weise ist es möglich, ein Halbleiterbauelement so weiter zu bilden, dass der MOSFET bei Erreichen einer kritischen Temperatur nicht einfach abgeschaltet wird, sondern dass z.B. seine Belastung durch Verringern der Leitfähigkeit herabgesetzt wird.

Aus der WO 96/02942 ist ein Gehäuse für Halbleiterbauelemente bekannt, welches einen Kühlkörper bzw. eine Wärmesenke aufweist. Dabei ist ein integriertes Halbleiterbauelement über Bonddrähte mit einem üblichen Leiterrahmen versehen, während es an seiner unteren Seite bzw. im Bereich seines Bodens über Polymermaterial mit einer plattenförmigen Wärmesenke bzw. einem Kühlkörper thermisch leitend verbunden ist. Das Material der Wärmesenke besteht vorzugsweise aus Aluminium oder aus Kupfer.

Weiterhin ist aus der EP 0 578 411 B1 eine Halbleiteranordnung mit einer an einem Leitungsrahmen angebrachten und in einem Kunststoffgehäuse vorgesehenen Halbleitervorrichtung bekannt, wobei die Oberfläche des Gehäuses über der Halbleitervorrichtung nach oben gerichtete einstückig ausgeformte Wärmeableitungselemente aufweist und diese Wärmeableitungselemente als konische Vorsprünge ausgebildet sind, die sich innerhalb eines direkt oberhalb der Halbleitervorrichtung vorgesehenen Bereiches erstrecken.

Weiterhin ist aus der EP 0 723 293 A1 eine Halbleiteranordnung mit einer Wärmesenke bekannt, bei der ein in einem Leiterrahmen montiertes Halbleiterelement direkt an eine Wärmesenke grenzt, welche für die Abfuhr der im Halbleiterbauelement entstehenden Wärme sorgt.

Aus der US 6,092,927 ist ein Verfahren zur Bestimmung der Temperatur eines Leistungshalbleiters bekannt, wobei ein integrierter analoger Schaltkreis zusammen mit dem Leistungshalbleiter auf einer Wärmesenke zusammengepackt ist; auf diese Weise ist es möglich, den thermischen Widerstand zwischen dem Leistungshalbleiter und dem integrierten Schaltkreis, die thermischen Widerstände zwischen dem Leistungshalbleiter und der Wärmesenke und zwischen dem analogen integrierten Schaltkreis und der Wärmesenke zu bestimmen. Somit ist es möglich, die Verlustleistung in dem Leistungshalbleiter zu bestimmen, in dem die Temperatur des integrierten Schaltkreises, die Temperatur der Wärmesenke unter Ausnutzung thermischer Kapazitäten sowie die Wärmesenkentemperatur und thermischen widerstände im Hinblick auf Spannung und Strom des integrierten Schaltkreises zu ermitteln. Dabei wird ein Ausgangssignal für ein asymptotisches Anzeigesystem der Temperatur des Leistungshalbleiters geschaffen.

Weiterhin ist aus der US 5,596,231 eine Wärmesenke, die selektiv mit elektrisch isolierendem Werkstoff beschichtet ist, für einen integrierten Schaltkreis vorgesehen, wobei das elektrisch isolierende Material anodisch oxidiertes Aluminium aufweist, welches durch Aufdampfen auf die Wärmesenke erzeugt worden ist. Die Wärmesenke selbst ist aus Kupfer oder KupferLegierungen gebildet, die wegen ihrer starken thermischen Leitfähigkeit ausgewählt sind.

Die gesamte integrierte Schaltungseinrichtung kann dabei in einem Plastikgehäuse untergebracht sein.

Weiterhin ist aus der WO 80/00878 ein Differentialkalorimeter bekannt, das nach dem Wärmesenkenprinzip arbeitet. Dabei ist ein Paar von Wärmekapazitätsmessstellen symmetrisch innerhalb eines mittleren Abschnitt der Wärmesenke angeordnet, wobei eine der Messzellen eine Referenzsubstanz erhält und die andere eine sogenannte Probesubstanz. Während einer Temperaturmessperiode werden Temperaturmessungen zu verschiedenen Zeitpunkten vorgenommen.

Die Erfindung stellt sich die Aufgabe, eine genaue und rasche Temperaturermittlung bei der Wärmeabfuhr aus integrierten Schaltungen im Bereich der Wärmesenke eines Halbleiterschaltelements vorzunehmen, wobei insbesondere Sensoren mit kleiner thermischer Masse zur Anwendung gelangen sollen.

Die Aufgabe wird dadurch gelöst, dass der Temperatursensor einen Dünnfilm-Messwiderstand aufweist, der auf einer elektrisch isolierenden Oberfläche eines folienartigen Substrats aufgebracht ist, wobei die gesamte Dicke des Temperatursensors im Bereich von 10 µm bis 100 µm liegt und wobei der Temperatursensor an den Kühlkörper thermisch angekoppelt ist.

Als besonders vorteilhaft erweist es sich, dass der Dünnfilm-Messwiderstand als Temperatursensor aufgrund seiner geringen Dicke nur eine kleine thermische Masse aufweist und somit eine Integration in den Heatsink-Bereich von Halbleiterchips ohne Veränderung des Kühlaufbaus ermöglicht.

Vorteilhafte Ausgestaltungen des Gegenstandes nach Anspruch 1 sind in den Ansprüchen 2 bis 15 angegeben.

In einer bevorzugten Ausführungsform des Temperatur-Sensors ist der Dünnfilm-Messwiderstand als ebenes Bauteil ausgebildet. Der Messwiderstand weist vorteilhafterweise eine Schicht in Form eines mäanderförmigen Musters auf und besteht im wesentlichen aus Platin oder einer Platinlegierung; die Dicke der Schicht liegt im Bereich von 0,8 bis 1,2 µm.

In einer vorteilhaften Ausgestaltung des Halbleiterbauelements ist der Temperatursensor zwischen der integrierten Schaltung und dem Kühlkörper angeordnet.

Weiterhin ist in einer vorteilhaften Ausgestaltung der Erfindung ist der Dünnfilm-Messwiderstand auf einem Substrat mit elektrisch isolierender Oberfläche aufgebracht, wobei das Substrat aus Metall, vorzugsweise aus Nickel, einer Nickellegierung oder aus einer Eisenlegierung mit einem Gehalt an Chrom und Aluminium besteht. Der Gehalt an Chrom liegt vorzugsweise bei ~20 Gew-%, während der Gehalt an Aluminium bei -5 Gew-% liegt. Diese Eisenlegierung ist in dem Buch _{"}Stahlschlüssel" von C. W. Wegst, Verlag Stahlschlüssel West GmbH Marbach 1998 (18. Auflage; ISBN 3-922599-14-1) auch mit der Werkstoffnummer 1.4767 und dem Kurznamen (DIN) CrAl 20 5 (X8CrAl20-5) versehen.

Als besonders vorteilhaft hat es sich erwiesen, dass Platin-Dünnfilm-Messwiderstände auf Nickelfolien oder Folien einer Nickel-Legierung bzw. einer Eisenlegierung mit einer Dicke im Bereich von 30 bis 80 µm aufgebracht werden können, woraus sich aufgrund geringer Wärmekapazität eine weitgehend verzögerungsfreie Temperaturbestimmung ergibt.

In einer bevorzugten Ausgestaltung der Erfindung ist der Dünnfilmmesswiderstand auf einer Isolationsschicht mit einer Dicke im Bereich von 2 bis 5 µm aufgebracht; die Isolationsschicht weist vorteilhafterweise Siliziumoxid oder Aluminiumoxid auf und ist im PVD-Verfahren auf das Substrat aufgebracht.

Weiterhin wird in einer vorteilhaften Ausgestaltung der Erfindung eine Passivierungsschicht auf den Dünnfilm-Messwiderstand aufgebracht; sie besteht vorzugsweise aus Siliziumoxid (SiO) oder Aluminiumoxid (Al₂O₃). Die Passivierungsschicht weist eine Dicke von 1 bis 5µm auf; sie ist mittels PVD-Verfahren aufgebracht.

Weiterhin ist in einer bevorzugten Ausführungsform der Dünnfilmmesswiderstand in einer Ebene angeordnet, wobei der Messwiderstand bzw. die Passivierungsschicht auf einer Seite mit einer an den Kühlkörper angrenzenden thermischen Ankopplungsschicht abgedeckt ist, während er auf der anderen Seite mit einem Substrat an einem Wärmeverteiler grenzt, der wenigstens zum Teil die integrierte Schaltung umgibt.

In einer vorteilhaften Ausgestaltung ist zwischen wenigstens einem Teil der integrierten Schaltung und dem Wärmeverteiler eine elektrisch isolierende, jedoch thermisch gut leitende Schicht angeordnet.

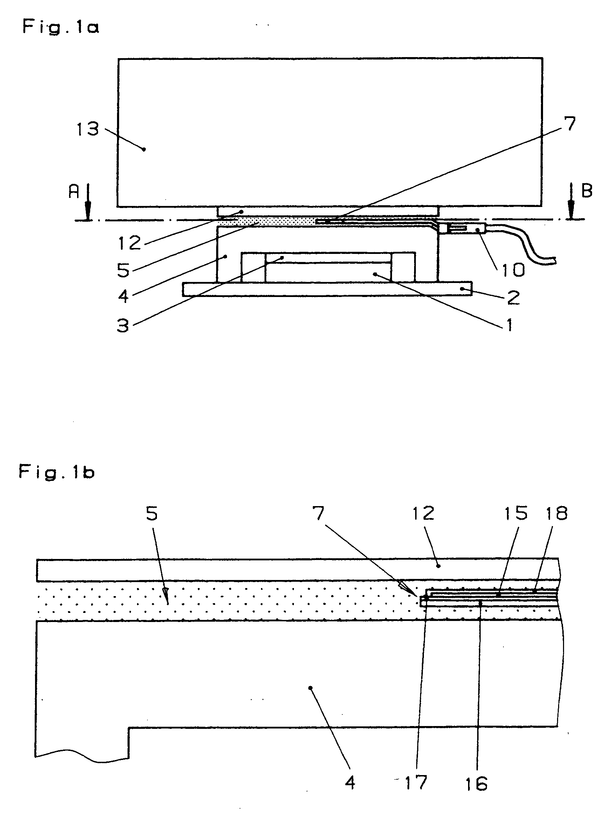

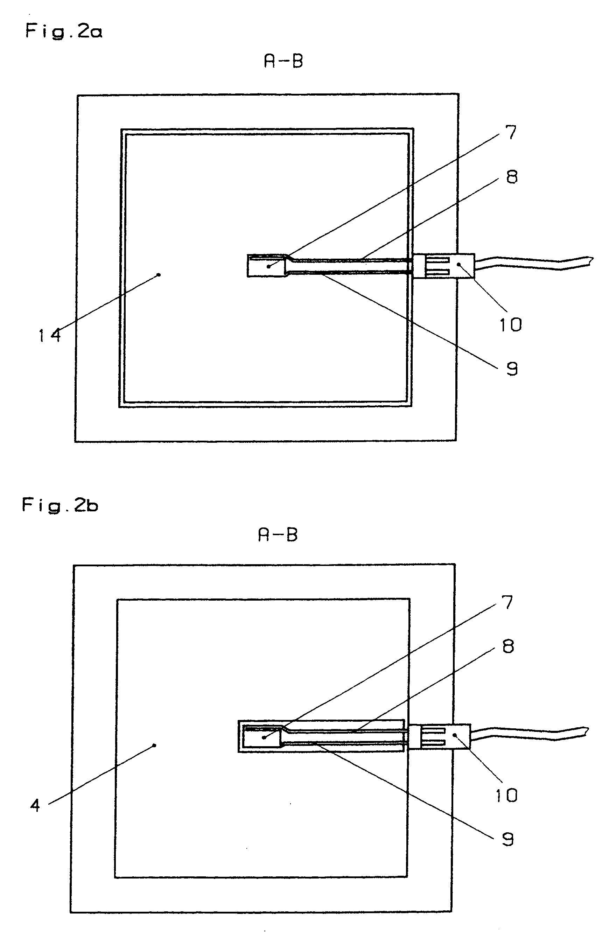

Im folgenden ist der Gegenstand anhand der Figuren 1a, 1b sowie 2a und 2b näher erläutert.

Figur 1a zeigt schematisch in einem Längsschnitt ein integriertes Halbleiterbauelement auf einem Substrat, wobei dieses von einem Wärmeverteiler weitgehend umgeben ist; weiterhin ist im Längsschnitt ein im Übergangsbereich zwischen Wärmeverteiler und Kühlkörper bzw. Wärmesenke angeordneter Temperatursensor erkennbar.

Figur 1b zeigt einen teilweise gebrochen dargestellten Ausschnitt nach Figur 1a, in dem der Aufbau des im Längsschnitt schematisch dargestellten Sensors zum Teil besser erkennbar ist.

Figur 2a zeigt in einer Draufsicht einen Temperatursensor (Schnitt A-B gemäß Figur 1a), welcher direkt zur Wärmesenke benachbart angeordnet ist.

Figur 2b zeigt eine alternative Darstellung zu Figur 2a (Schnitt A-B gemäß Figur 1a).

Gemäß Figur 1a befindet sich ein Halbleiterbauelement mit integrierter Schaltung 1 auf einem Substrat 2 mit elektrisch isolierender Oberfläche, wobei die dem Substrat 2 abgewandte Seite der integrierten Schaltung 1 über eine wärmeleitende Schicht 3 an einen Wärmeverteiler 4 thermisch angekoppelt ist. Der Wärmeverteiler 4 umschließt dabei wenigstens teilweise die auf dem Substrat 2 befindliche integrierte Schaltung 1, wobei jedoch der mit dem Substrat 2 verbundene Bereich bzw. Bodenbereich der integrierten Schaltung 1 freigelassen ist.

Auf der dem Substrat 2 abgewandten Seite des Wärmeverteilers 4 befindet sich eine elektrisch isolierende jedoch thermisch gut leitende Schicht 5 als thermische Ankoppelungsschicht, auf der ein flächenhaft ausgebildeter elektrischer Dünnschichtwiderstand auf Platinbasis als Temperatursensor 7 angeordnet ist. Der Temperatursensor 7 weist eine ebene zickzackförmige oder mäanderförmige Widerstandsschicht als Messwiderstand auf, welche über ebenfalls in Dünnschichttechnik ausgeführte Anschlussleitungen 8, 9 (Figur 2a, 2b) mit einem Außenanschluss 10 verbunden ist.

Gemäß Figur 1b ist der Messwiderstand 15 des Temperatursensors 7 auf einer Nickelfolie oder einer Folie 16 aus einer Nickellegierung, bzw. einer Folie aus einer Eisenlegierung der Werkstoffnummer 1.4767 (Stahlschlüssel) aufgebracht, wobei sich zwischen der Folie 16 und dem Messwiderstand 15 zusammen mit den in dieser Figur nicht gezeigten Anschlussleitungen eine elektrisch isolierende Schicht bzw. Isolationsschicht 17 mit einer Dicke im Bereich von 2 bis 5 µm befindet. Die Isolationsschicht 17 besteht aus Siliziumoxid oder aus Aluminiumoxid.

Weiterhin ist im Längsschnitt gemäß Figur 1a bzw. Figur 1b eine zweite thermische Ankopplungsschicht 12 erkennbar, die auf ihrer dem Wärmeverteiler 4 abgewandten Seite mit einer Wärmesenke 13 bzw. einem Kühlkörper thermisch in Verbindung steht. Die Wärmesenke 13 besteht vorzugsweise aus thermisch gut leitendem Werkstoff, wie beispielsweise Kupfer oder Aluminium.

Die wärmeleitenden Schichten 3, 5 und 12 gemäß Figur 1a bestehen aus einem elektrisch isolierenden, jedoch thermisch gut leitenden Material, wie z.B. keramikgefüllten Wärmeleitklebern.

Mit Hilfe des Temperatursensors 7 ist es somit möglich, die aus dem Bereich des Wärmeverteilers 4 zur Wärmesenke 13 strömende Wärmemenge zu erfassen und mit Hilfe eines so ermittelten Temperatursignals die integrierte Schaltung 1 beispielsweise durch Umschaltmaßnahmen vor Überhitzung zu schützen.

Die anhand Figur 2a erkennbare Aluminiumnitridschicht 14 fehlt bei der Anordnung gemäß Figur 2b, so dass hier der Temperatursensor 7 direkt auf der Außenoberfläche des Wärmeverteilers 4 aufgebracht ist.

## Patentansprüche

1. Halbleiterbauelement mit einer integrierten Schaltung und einem damit thermisch verbundenen Temperatursensor, dessen Widerstand von der Temperatur abhängig ist, sowie mit einem Kühlkörper als Wärmesenke, **dadurch gekennzeichnet, dass** der Temperatursensor (7) einen Dünnfilm-Messwiderstand (15) aufweist, der auf einer elektrisch isolierenden Oberfläche eines folienartigen Substrats (16) aufgebracht ist, wobei die gesamte Dicke des Temperatursensors im Bereich von 10 µm bis 100 µm liegt und der Temperatursensor (7) an den Kühlkörper (13) thermisch angekoppelt ist.

2. Halbleiterelement nach Anspruch 1, **dadurch gekennzeichnet, dass** der Dünnfilm-Messwiderstand (15) als ebenes Bauteil ausgebildet ist.

3. Halbleiterelement nach Anspruch 1 oder 2, **dadurch gekennzeichnet, dass** der Temperatursensor (7) zwischen der integrierten Schaltung (1) und dem Kühlkörper (13) angeordnet ist.

4. Halbleiterelement nach einem der Ansprüche 1 bis 3, **dadurch gekennzeichnet, dass** der Dünnfilm-Messwiderstand (15) auf einer elektrisch isolierenden Oberfläche eines folienartigen Substrats (16) aus Metall aufgebracht ist.

5. Halbleiterelement nach Anspruch 4, **dadurch gekennzeichnet, dass** die elektrisch isolierende Oberfläche aus einer Isolationsschicht (17) mit einer Dicke im Bereich von 2 bis 5 µm gebildet ist.

6. Halbleiterelement nach Anspruch 5, **dadurch gekennzeichnet, dass** die Isolationsschicht (17) Siliziumoxid oder Aluminiumoxid aufweist.

7. Halbleiterelement nach Anspruch 6, **dadurch gekennzeichnet, dass** die Isolationsschicht (17) mittels PVD-Verfahren aufgebracht ist.

8. Halbleiterelement nach einem der Ansprüche 1 bis 7, **dadurch gekennzeichnet, dass** das folienartige Substrat (16) für den Dünnfilm-Messwiderstand (15) Nickel, eine Nickel-Legierung oder eine Eisenlegierung mit einem Gehalt an Chrom und Aluminium aufweist.

9. Halbleiterelement nach Anspruch 8, **dadurch gekennzeichnet, dass** das folienartige Substrat (16) aus einer Nickelfolie, einer Folie aus Nickellegierung oder einer Folie aus der Eisenlegierung mit einem Gehalt an Chrom und Aluminium mit einer Dicke im Bereich von 30 bis 80 µm besteht.

10. Halbleiterbauelement nach einem Ansprüche 1 bis 9, **dadurch gekennzeichnet, dass** eine Passivierungsschicht (18) aus Siliziumoxid oder Aluminiumoxid auf den Dünnfilm-Messwiderstand (15) aufgebracht ist.

11. Halbleiterelement nach Anspruch 10, **dadurch gekennzeichnet, dass** die Passivierungsschicht (18) eine Dicke im Bereich von 1 bis 5 µm aufweist.

12. Halbleiterelement nach Anspruch 10 oder 11, **dadurch gekennzeichnet, dass** die Passivierungsschicht (18) mittels PVD-Verfahren aufgebracht ist.

13. Halbleiterbauelement nach einem Ansprüche 1 bis 12, **dadurch gekennzeichnet, dass** der Dünnfilm-Messwiderstand (15) auf einer Seite mit einer an den Kühlkörper (13) angrenzenden thermischen Ankopplungsschicht (12) versehen ist, während er auf der anderen Seite mit seinem Substrat an einen Wärmeverteiler (4) grenzt, der benachbart zur integrierten Schaltung (1) angeordnet ist.

14. Halbleiterelement nach Anspruch 13, **dadurch gekennzeichnet, dass** der Wärmeverteiler (4) wenigstens zum Teil die integrierte Schaltung (1) umgibt.

15. Halbleiterbauelement nach Anspruch 13 oder 14, **dadurch gekennzeichnet, dass** zwischen einem Teil der integrierten Schaltung (1) und dem Wärmeverteiler (4) eine elektrisch isolierende, thermisch gut leitende Schicht angeordnet ist.
